# EUROPEAN PATENT SPECIFICATION

(11) **EP 2 858 049 B1**
(45) Date of publication and mention of the grant of the patent: **25.04.2018**
(21) Application number: 14186751.5
(22) Date of filing: 29.09.2014
(51) Int. Cl.: G08B 13/24

(54) **System and method for loss prevention using a magnetometer**
System und Verfahren zur Verlustverhütung mit einem Magnetometer
Système et procédé de prévention de perte à l'aide d'un magnétomètre

(30) Priority: 04.10.2013 US 201361886923 P
(43) Date of publication of application: 08.04.2015
(73) Proprietor: Checkpoint Systems, Inc., Thorofare, NJ 08086 (US)
(72) Inventor: Baker, Vincent W., Westville, NJ New Jersey 08093 (US)
(74) Representative: Ström & Gulliksson AB

(56) References cited:
- US-A- 3 754 225
- US-A- 5 008 649
- US-A- 5 654 686
- US-A1- 2010 219 951

## Description

### FIELD OF THE INVENTION

The field of the present invention relates to systems and methods for retail store security and loss prevention.

### BACKGROUND OF THE INVENTION

Loss of merchandise in stores by theft is a significant problem faced daily by most business establishments that display merchandise on a sales floor. Many businesses have implemented point of egress loss prevention detectors, in combination with specialized tags placed on the merchandise, as one line of defense in their loss prevention programs. Some types of these specialized anti-theft tags are secured to merchandise using mechanisms which require a magnetic tool for detaching the tags at the point of sale.

However, even with such systems in place, problems still exist when shoplifters remove the tags from the merchandise. Removal of the anti-theft tags is often achieved by a shoplifter illicitly bringing a magnetic detacher into the area where merchandise is displayed, surreptitiously removing the anti-theft tag and leaving it stashed away somewhere on or around the sales floor, then leaving the store with the merchandise that is now tag-free.
US3754225 (D1) discloses a system for detecting when objects such as typewriters are being stolen. An elastically-supported magnet is mounted on the typewriter.
US5654686 and US2010219951 disclose vehicle theft detection systems that mount a magnetometer within a vehicle to measure the earth's magnetic field. A theft is indicated when an unauthorized angular motion is detected.
It is therefore an aim of the present invention to determine whether an individual, one who may be masquerading as a patron of the business, is in possession of a magnetic detacher, especially to a degree of certainty which would permit a legal search of the individual.
This aim is attained by the features of the attached claims.

### SUMMARY OF THE INVENTION

The present invention is directed toward a system and method for for detecting the presence of an unauthorized magnetic detacher of anti-theft tags using a magnetometer. The magnetometer may be used as a first line of defense in a larger loss prevention scheme, or it may be used as a tool to verify suspected loss events. The magnetometer may be incorporated into a portable device, to facilitate use as a verification tool, it may be constructed as a stand-alone unit placed in strategic locations on a sales floor near merchandise, or it may be incorporated into other loss prevention equipment.

The present device further includes a processor operatively coupled to the magnetometer. The magnetometer is configured to measure intensities and directions of one or more maxima in a magnetic field, the one or more maxima including at least a first maximum from magnetic north of the Earth, wherein a first intensity and a first direction are associated with the first maximum. The processor is configured to ignore the first intensity and the first direction associated with the first maximum and to determine whether the one or more maxima includes a second maximum distinct from and larger than the first maximum.

A system for preventing loss of an object from a sales floor includes a first loss prevention device and a second loss prevention device. The first loss prevention device includes a magnetometer and a processor operatively coupled to the magnetometer. The magnetometer is configured to measure intensities and directions of one or more maxima in a magnetic field, the one or more maxima including at least a first maximum from magnetic north of the Earth, wherein a first intensity and a first direction are associated with the first maximum. The processor is configured to ignore the first intensity and the first direction associated with the first maximum and to determine whether the one or more maxima includes a second maximum distinct from the first maximum. The second loss prevention device is positioned at a point of egress and is configured to detect a loss event indicia and to communicate detection of the loss event indicia. The first loss prevention device is activated following communication of the detected loss event indicia.

A method is also described, including receiving notification of a loss event indicia and activating a first loss prevention device. The first loss prevention device includes a magnetometer and a processor operatively coupled to the magnetometer. The magnetometer is configured to measure intensities and directions of one or more maxima in a magnetic field, the one or more maxima including at least a first maximum from magnetic north of the Earth, wherein a first intensity and a first direction are associated with the first maximum. The processor is configured to ignore the first intensity and the first direction associated with the first maximum and to determine whether the one or more maxima includes a second maximum distinct from the first maximum.

A method is also described, including proving a first loss prevention device; detecting a loss event indicia associated with a person passing a second loss prevention device positioned at a point of egress; communicating detection of the loss event indicia by the second loss prevention device; and activating the first loss prevention device, following communication of the loss event indicia. The first loss prevention device includes a magnetometer and a processor operatively coupled to the magnetometer. The magnetometer is configured to measure intensities and directions of one or more maxima in a magnetic field, the one or more maxima including at least a first maximum from magnetic north of the Earth, wherein a first intensity and a first direction are associated with the first maximum. The processor is configured to ignore the first intensity and the first direction associated with the first maximum and to determine whether the one or more maxima includes a second maximum distinct from the first maximum. Activation of the first loss prevention device, and detection of the second maximum, provides confirmation of the loss event indicia.

A method is also described including monitoring a local magnetic field using a first loss prevention device and transmitting, by the processor of the first loss prevention device, confirmation data to a server when the one or more maxima includes the second maximum. The first loss prevention device includes a magnetometer and the processor operatively coupled to the magnetometer. The magnetometer is configured to measure intensities and directions of one or more maxima in a magnetic field, the one or more maxima including at least a first maximum from magnetic north of the Earth, wherein a first intensity and a first direction are associated with the first maximum. The processor is configured to ignore the first intensity and the first direction associated with the first maximum and to determine whether the one or more maxima includes a second maximum distinct from the first maximum.

Accordingly, an improved system and method for loss prevention using a magnetometer are disclosed. Advantages of the improvements will be apparent from the drawings and the description of the preferred embodiment.

### BRIEF DESCRIPTION OF THE DRAWINGS

The foregoing summary, as well as the following detailed description of the exemplary embodiments, will be better understood when read in conjunction with the appended drawings. It should be understood, however, that the invention is not limited to the precise arrangements and instrumentalities shown in the following figures:
Fig. 1 schematically illustrates a loss detection device;
Fig. 2 illustrates a display screen of a loss detection device;
Fig. 3 schematically illustrates a loss detection system;
Fig. 4 is a flowchart of a first process for loss detection;
Fig. 5 is a flowchart of a second process for loss detection;
Fig. 6 shows a representative 3 axis data plot of magnetic field strength;
Fig. 7 schematically illustrates a second loss prevention system;
Fig. 8 is a flowchart of the third process of loss detection;
Fig. 9 schematically illustrates a second loss detection device; and
Fig. 10 schematically illustrates a third loss system.

### DETAILED DESCRIPTION OF THE INVENTION

Features of the present invention may be implemented in software, hardware, firmware, or combinations thereof. The computer programs described herein are not limited to any particular embodiment, and may be implemented in an operating system, application program, foreground or background processes, driver, or any combination thereof. The computer programs may be executed on a single computer or server processor or multiple computer or server processors.

Processors described herein may be any central processing unit (CPU), microprocessor, micro-controller, computational, or programmable device or circuit configured for executing computer program instructions (e.g. code). Various processors may be embodied in computer and/or server hardware of any suitable type (e.g. desktop, laptop, notebook, tablets, cellular phones, etc.) and may include all the usual ancillary components necessary to form a functional data processing device including without limitation a bus, software and data storage such as volatile and non-volatile memory, input/output devices, graphical user interfaces (GUIs), removable data storage, and wired and/or wireless communication interface devices including Wi-Fi, Bluetooth, LAN, etc.

Computer-executable instructions or programs (e.g. software or code) and data described herein may be programmed into and tangibly embodied in a non-transitory computer-readable medium that is accessible to and retrievable by a respective processor as described herein which configures and directs the processor to perform the desired functions and processes by executing the instructions encoded in the medium. A device embodying a programmable processor configured to such non-transitory computer-executable instructions or programs is referred to hereinafter as a "programmable device", or just a "device" for short, and multiple programmable devices in mutual communication is referred to as a "programmable system". It should be noted that non-transitory "computer-readable medium" as described herein may include, without limitation, any suitable volatile or non-volatile memory including random access memory (RAM) and various types thereof, read-only memory (ROM) and various types thereof, USB flash memory, and magnetic or optical data storage devices (e.g. internal/external hard disks, floppy discs, magnetic tape CD-ROM, DVD-ROM, optical disk, ZIP™ drive, Blu-ray disk, and others), which may be written to and/or read by a processor operably connected to the medium.

In certain embodiments, the present invention may be embodied in the form of computer-implemented processes and apparatuses such as processor-based data processing and communication systems or computer systems for practicing those processes. The present invention may also be embodied in the form of software or computer program code embodied in a non-transitory computer-readable storage medium, which when loaded into and executed by the data processing and communications systems or computer systems, the computer program code segments configure the processor to create specific logic circuits configured for implementing the processes.

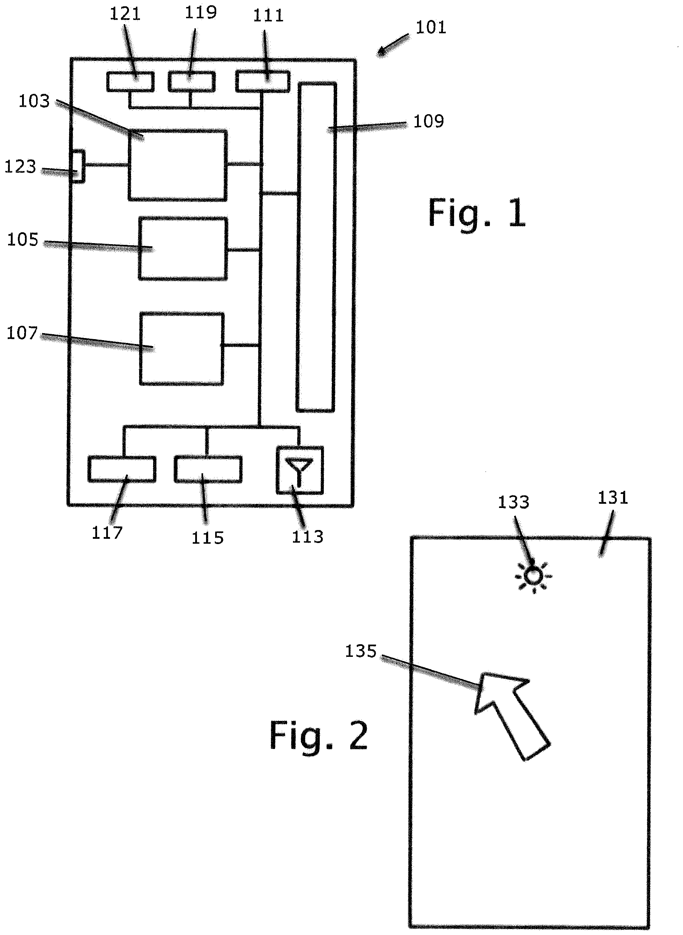

Turning in detail to the drawings, a loss prevention device 101 is shown in Fig. 1. This device 101 includes a programmable processor 103 communicably coupled to the other components, which include one or more types of memory 105, a magnetometer 107, a display 109, a global positioning system (GPS) subsystem 111, a transceiver subsystem 113, an audio subsystem 115, and a video subsystem 117, an accelerometer 119, a gyroscope 121, and one or more actuatable buttons 123 which a user may use to control operation of the device 101 through the software programming of the processor 103. One or more of the subsystems may be at least partially integrated within the processor 103. The processor 103 is programmed, either through software programming or hardware programming, to utilize each of the components for carrying out the programming. The processor 103 operatively communicates with the memory 105 to store and retrieve programming and/or data during use as instructed by programming, whether that programming is represented in software stored in the memory or hard coded into other components of the device 101. The programming and/or data may be generated by one or more components of the loss prevention device, or they may be obtained from external sources through the transceiver subsystem 113.

The GPS subsystem 111 operates in conjunction with the processor 103 to determine the longitude and latitude of the device during operation, in a manner which is well-known in the art. Other location determination subsystems may be substituted for, or included in addition to, the GPS subsystem 111.

The transceiver subsystem 113 operates in conjunction with the processor 103 to communicate with other devices over a network and/or directly with other devices in an ad hoc network. The other devices may be similar to the loss prevention device 101, or they may be other types of computing devices, such as personal computers, servers, and mobile personal devices (e.g., smart phones, feature phones, and the like). The transceiver subsystem 113 may be configured to communicate wirelessly and/or via a wired connection. Such communication subsystems are well-known in the art, including those that may be incorporated into handheld devices, such as those included in mobile phones and smart phones.

The audio subsystem 115 operates in conjunction with the processor 103 to provide audio input and/or output from the device. The audio subsystem 115 may therefore include one or more microphones and one or more speakers. Such audio subsystems are also well-known in the art, including those that may be incorporated into handheld devices.

The video subsystem 117 operates in conjunction with the processor 103 to generate still images and motion video. The video subsystem 117 includes one or more cameras, and when one of the cameras is used in tandem with the audio subsystem 115, full motion video with synchronized sound may be recorded. Such video subsystems are also well-known in the art, including those that may be incorporated into handheld devices.

The magnetometer 107 is a vector-type magnetometer, and it produces an electronic signal in response to the local magnetic field. The signal reflects both the intensity of the magnetic field, including localized maxima, and the direction of those localized maxima relative to the magnetometer. The processor 103 receives the electronic signal from the magnetometer 107 and analyzes that signal to determine the presence of maxima in the signal. As described in more detail below, one of the maxima detected in the signal is from magnetic north of the Earth. This maxima is ignored by the processor, and the signal is analyzed for the presence of additional maxima in the signal. These additional maxima, when present, may indicative of another magnetic source near the loss detection device.

The accelerometer 119 and the gyroscope 121 are of the type that are commonly known in the art, and may be of the type that are suited to be incorporated into a handheld device, such as a smart phone. In addition, both the accelerometer 119 and the gyroscope 121 may be integrated into a single motion detection integrated circuit-on-a-chip, such as are well-known to those of skill in the art. The accelerometer 119 and gyroscope 121 may be used in combination, again in a manner that is well-known to those of skill in the art, to determine and track the orientation of the device into which they are incorporated.

The process for ignoring the maxima resulting from magnetic north can also be used to exclude maxima which have an intensity less than that of magnetic north. The remaining maxima in the signal will have stronger intensities than magnetic north, and these stronger intensities are indicative of strong magnets within the vicinity of the loss prevention device. Alternatively, the processor may exclude maxima within a range around the known intensity of magnetic north, so that stronger and weaker maxima may be detected with use of a appropriately sensitive magnetometer.

Any one or more of several different vector-type magnetometers may be used, depending upon the design specifications of the loss prevention device (e.g., whether or not it is a handheld device) and the desired sensitivity, such as a rotating coil magnetometer, a hall effect magnetometer, a magnetoresistive magnetometer, a fluxgate magnetometer, among others. Such magnetometers are well-known in the art. In particular, magnetoresistive magnetometers are frequently incorporated into handheld devices, such as smart phones and electronic compasses. The magnetometer in the loss prevention device 101 should be at least sensitive enough to detect the maximum in the local magnetic field created by magnetic north of the Earth. With such sensitivity, the loss prevention device would be enabled to detect other, stronger localized maxima, from up to about 18-24 inches distance. However, depending upon the design of the loss prevention device and the desired use of the device (i.e., whether the device is handheld by loss prevention personnel or placed in a stationary position in the vicinity of merchandise displayed for sale), it may be desirable to include in the loss prevention device a magnetometer with greater sensitivity. However, the inclusion of a magnetometer with greater sensitivity increases the amount of signal processing that the processor needs to perform in order to associate a localized maximum with the potential theft of merchandise.

The display 109 may be a touch-sensitive LED type of display screen, color or black and white, and it is controlled by the processor to display information related to loss prevention. Other types of displays may be used, such as a series of LEDs, a liquid crystal display, an organic LED display, or any other type of component to create a visual representation of the information. An LED type of display screen is the most versatile, and the information displayed may include a visual indicator showing the presence of a second maximum in the local magnetic field, a directional indicator showing the direction of the point of origin of the second maximum, the GPS coordinates as a location identifier for the device, the time and date of the detection, any pictures or video associated with the detection, and/or a representation of audio data from an audio recording associated with the detection, among other things.

Smart phones that are readily available on the market today include most of the hardware features described above. However, off-the-shelf smart phones are not programmed to utilize signals generated by the magnetometer in the manner described herein. Alternatively, depending upon how the device will be used, it may be advantageous to construct a loss prevention device as a special use device. Cost advantages may be realized if certain components that are included in off-the-shelf smart phones are not needed for the implementation of the loss prevention processes and procedures for which the loss prevention device will be used.

Fig. 2 illustrates how two components of this information may be shown on an LED display screen 131. An icon 133 is placed near the top of the display screen 131 to represent whether a maximum is detected within the localized magnetic field. The icon 133 may change appearance to indicate when a second maximum is present. Multiple icons may be displayed for devices that are configured to identify the presence of multiple other maxima that are distinct from magnetic north. The arrow 135 serves as a directional indicator that indicates the direction of the origination point of a second maximum detected within the localized magnetic field. The arrow 135 may be made to appear to rotate about three axes to indicate the relative direction of the second maximum with respect to the orientation of the device 101. The relative direction of the second maximum with respect to the orientation of the device 101 may be determined using the combination of the magnetometer 107, the accelerometer 119, and the gyroscope 121 using processes already well-known to those of skill in the art. Multiple arrows may be displayed for devices that are configured to identify the presence of multiple other maxima that are distinct from magnetic north.

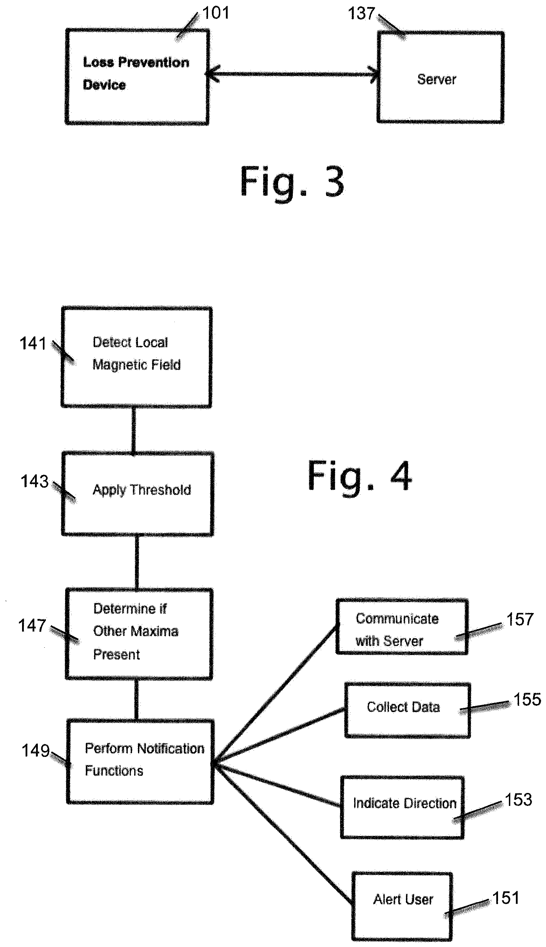

A loss prevention device 101 communicably connected to a server 137 is illustrated in Fig. 3. The loss prevention device 101 uses the transceiver subsystem to communicate with the server via a wired connection or via a wireless connection, depending upon the design needs of the loss prevention system. The server 137 may be programmed with any type of functionality that suits the design needs of the loss prevention system, e.g., it may be a relay server, an email server, an application server, a data server, and the like.

A flowchart showing a data process flow that may be programmed into a loss prevention device 101 is shown in Fig. 4. This process may be performed repeatedly when the programming on the loss prevention device is activated, or it may be performed upon activation of the process by the user. The magnetometer of the loss prevention device detects the local magnetic field 141, then a threshold is applied 143 to eliminate the maximum that results from magnetic north of the Earth. In one embodiment, since magnetic north has a constant intensity (even if not a constant direction), the part of the signal from the magnetometer that represents magnetic north may be eliminated by application of a threshold to the signal, thereby effectively eliminating parts of the signal below that threshold value. In other embodiments, especially those where more sensitive magnetometers are used to detect weaker maxima, an upper threshold value above the known magnetic north constant intensity level may be applied, along with a lower threshold to effectively eliminate a middle intensity range in the magnetometer signal. After application of the one or more threshold values to the magnetometer signal, the resulting signal is analyzed for the presence of other maxima 147. In the event that one or more other maxima are determined to be present, the loss prevention device may automatically activate one or more notification functions 149. Alternatively, upon determining that one or more other maxima are present, the loss prevention device may alert the user about the presence of the one or more other maxima, and then make available to the user for activation the one or more notification functions 149. Some of the options for notification functions when an additional maximum (or more than one) is present include making a visual or audible alert to show the presence of the additional maximum 151, indicating the relative direction 153 of the additional maximum from the position of the loss prevention device, enabling a mode for collecting addition data 155, and/or transmitting confirmation data to a server 157.

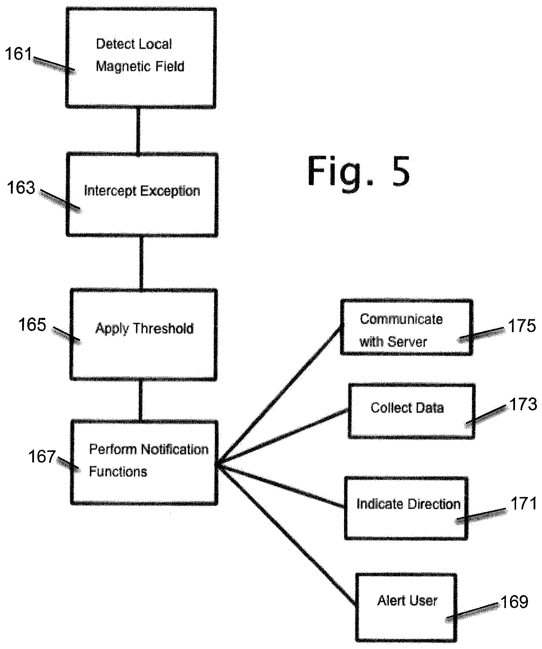

A flowchart showing an alternative data process flow that may be programmed into a loss prevention device 101 is shown in Fig. 5. This programming is intended to work with off-the-shelf smart phones, and other such devices, which have preprogrammed operating systems and the API's associated with those operating systems. In an off-the-shelf smart phone, a magnetic field in the vicinity of the device is detected 161, and when multiple maxima are detected by the magnetometer, the operating system of these off-the-shelf devices generally generates an exception to indicate to the user that recalibration is needed to differentiate between and identify magnetic north among the different maxima. In the loss prevention device, this exception is intercepted 163 by the loss prevention programming, so that the loss prevention programming may then apply the threshold 165 (the operating system of the device has already determined that a second maximum is present) and activate one or more notification functions 167. Again, some of the options for notification functions when an additional maximum (or more than one) is present include making a visual or audible alert to show the presence of the additional maximum 169, indicating the relative direction 171 of the additional maximum from the position of the loss prevention device, enabling a mode for collecting addition data 173, and/or transmitting confirmation data to a server 175.

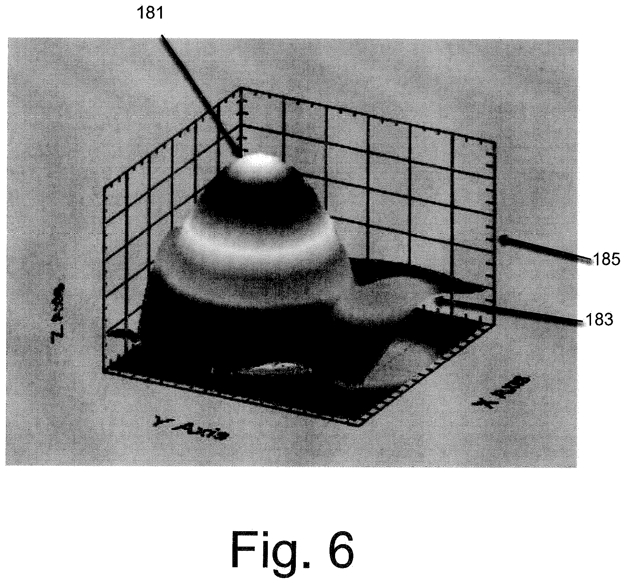

Fig. 6 is a 3D plot representative of data from the electronic signal of a magnetoresistive magnetometer in an off-the-shelf smart phone device. In the plot, the highest maximum 181 represents the magnetic field from a nearby source, such as a strong rare-earth magnet, and the next highest maximum 183 represents magnetic north of the Earth. Each maximum represents the intensity of the respective magnetic sources in the local magnetic field around the loss prevention device. Although the highest maximum 181 is shown as being chiefly along the z-axis, actual data from a magnetometer may result in maxima chiefly along any one or two of the three axis, and different maxima may be chiefly along different axes. For the data shown, applying a threshold filter, using a predetermined threshold value, e.g., at the indicated z-axis value 185, would effectively remove the magnetic north maximum 183 from the data. The remaining data would include only the highest maximum 181, and the presence of the highest maximum is due to the presence of another magnetic source, one that is nearby the loss prevention device. In the manner described above, the loss prevention device could then alert to the presence of this second maximum 181.

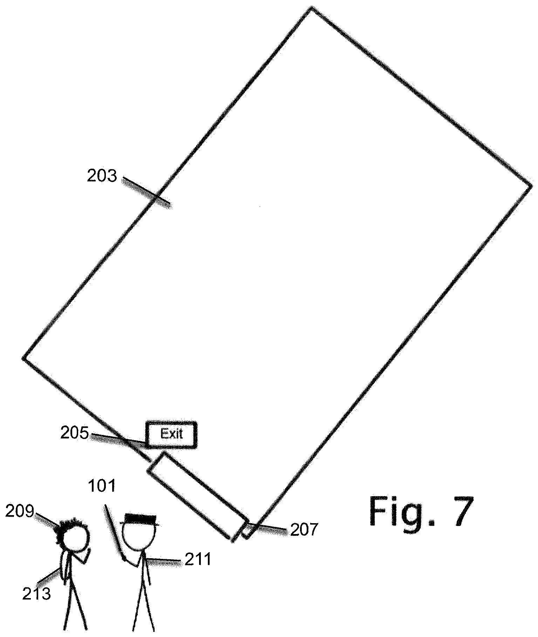

An embodiment of a loss prevention system is shown in Fig. 7. This system is used in conjunction with a sales floor 203, which may alternatively be any area in which merchandise is kept or displayed prior to sales. The sales floor 203 has a point of egress 205 where a second type of loss prevention device 207 is positioned. This second loss prevention device 207 generally spans the point of egress 205 and is configured to detect a predetermined mass of metal and/or anti-theft tags passing through the point of egress 205. Such loss prevention devices, and their functionality, are well-known in the art. When an individual 209 passes through and triggers the second loss prevention device, store personnel or security 211 uses the first loss prevention device 101 to determine if a further search of the individual 209 is warranted. For example, the first loss prevention device may indicate that a magnet is present in a backpack 213 or any other type of bag, container, pocket, etc., in the possession of the individual 209.

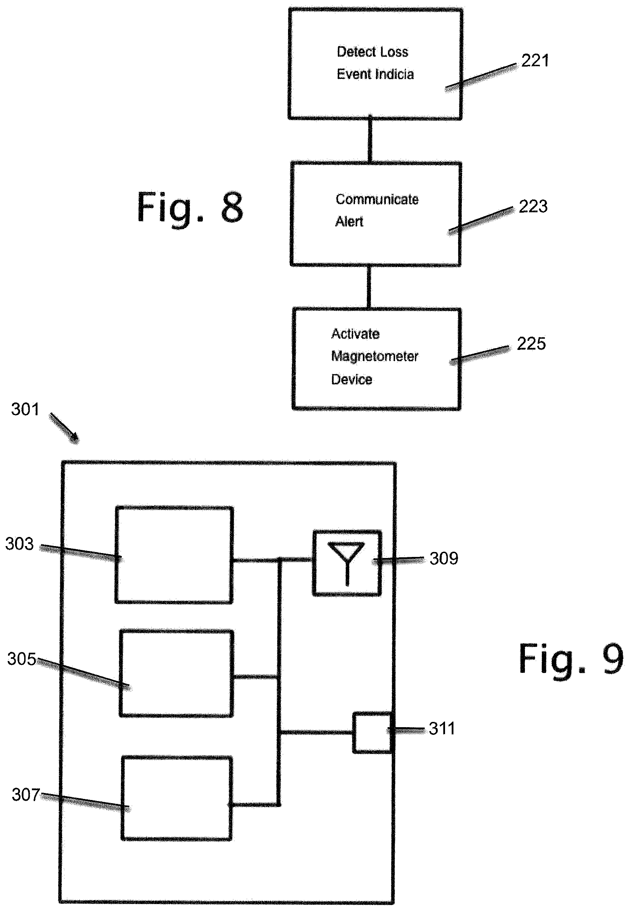

The process of loss prevention using the two loss prevention devices 101, 207 is shown in Fig. 8. The second loss prevention device 207 detects 221 an individual 209 in possession of an amount of metal over the predetermined mass or a magnet over a predetermined strength passing through the point of egress 205 and provides an alert 223 to communicate the detection. The passing of the predetermined mass of metal or predetermined strength of magnet by the second loss prevention device 207 and through the point of egress 205 is the loss event indicia, and the alert 223 is triggered by detection of the loss event indicia. The predetermined mass of metal and/or predetermined strength of magnet is set so that the alert 223 is coincident with a loss event indicia, and this predetermined mass may be different depending upon the anti-theft tags used. It is desirable that the predetermined mass or predetermined magnetic strength is the equivalent to the mass of or strength of a magnet that is of sufficient strength to detach an anti-theft tag. The alert 223 may be an audible sound, visible lights, or other form of communication to store personnel, security, or security systems associated with the sales floor 203, e.g. a server or other computing system used to monitor sales floor security.

An alert by the second loss prevention device 207 is often insufficient in and of itself to allow store personnel to question, detain, or possibly search an individual. Therefore, the first loss prevention device 101 may be activated 225 to help provide sufficient cause, should such cause be necessary. The alert by the second loss prevention device 207 may be used to automatically trigger activation of the first loss prevention device 101, or the first loss prevention device may be activated manually by store personnel or security 211.

Sufficient cause may be established in circumstances when the first loss prevention device 101 detects a second maximum in the localized magnetic field, i.e. a maximum that is not due to magnetic north of the Earth. In embodiments where store personnel or security 211 activate 225 the first loss prevention device 101, they can move it around in the vicinity of, but not touching, the individual 209 (or individuals) who passed by the second loss prevention device 207 at the time an alert is triggered. By moving the first loss prevention device 101 in the vicinity of the individual 209, the store personnel or security 211 is able to determine if the individual 209 is in possession of a magnet. Confirmation that the individual 209 is in possession of a magnet confirms the loss event indicia and may provide sufficient cause for questioning, detaining, and/or searching the individual.

An alternative embodiment of a loss prevention device 301 is illustrated in Fig. 9. This loss prevention device 301 is configured as a specialized device, and it includes a programmable processor 303 communicably coupled to the other components, which include one or more types of memory 305, a magnetometer 307, a transceiver subsystem 309, and one or more actuatable buttons 311 which a user may use to control operation of the device 101 through the software programming of the processor 303. Alternatively, the device may be configured to be controlled remotely through the transceiver subsystem 209. The functionality of each of these components is similar to those described above for the embodiment shown in Fig. 1.

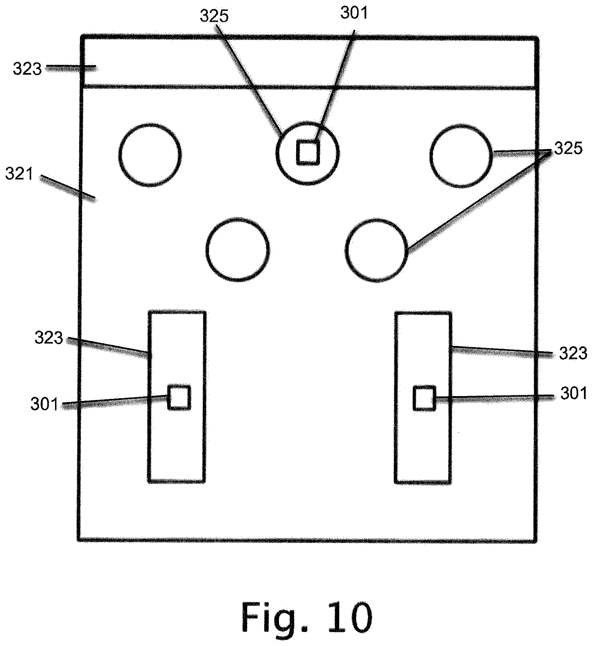

This alternative loss prevention device 301 is intended for placement in and around a sales floor 321 as shown in Fig. 10. The sales floor 321 includes different types of shelves 323 and racks 325 for displaying merchandise, and one or more of the loss prevention devices 301 are strategically placed around the sales floor 321 to detect the magnetic field around the sales floor 321, which is monitored for the presence of maximums in addition to the maximum from magnetic north of the Earth. For these stationary loss prevention devices 301, it is beneficial for them to include a magnetometer which is sufficiently sensitive to detect maxima in the localized magnetic field at greater distances as compared to off-the-shelf devices discussed above. The level of sensitivity appropriate is dependent upon factors such as the layout of the sales floor, the number of loss prevention devices placed, and the placement of those devices. When an additional maximum is detected, the loss prevention device 301 may communicate the presence of that maximum to store personnel and/or security, using the transceiver subsystem 309, and a further investigation of individuals on the sales floor 301 may ensue. Such further investigation may include the store personnel and/or security patrolling the sales floor 321 with a handheld loss prevention device, of the type shown in Fig. 1. Where multiple loss prevention devices are included around a sales floor, triangulation may be used to track an additional maximum as the magnetic source of the additional maximum moves about the sales floor.

While the invention has been described with respect to specific examples including presently preferred modes of carrying out the invention, those skilled in the art will appreciate that there are numerous variations and permutations of the above described systems and techniques. It is to be understood that other embodiments may be utilized and structural and functional modifications may be made without departing from the scope of the present invention. Thus, the spirit and scope of the invention should be construed broadly as set forth in the appended claims.

## Claims

1. A device for detecting the presence of an unauthorized magnetic detacher of anti-theft tags, the device comprising:
a magnetometer (107) configured to measure intensities and directions of one or more maxima in a magnetic field, the one or more maxima including a first maximum from magnetic north of the Earth, wherein a first intensity and a first direction are associated with the first maximum; and
a processor (103) operatively coupled to the magnetometer (107) and configured to ignore the first intensity and the first direction associated with the first maximum and to determine whether the one or more maxima includes a second maximum distinct from and larger than the first maximum.

2. The device of claim 1, further comprising a display screen operatively coupled to the processor (103), wherein the processor is further configured to display a visual indicator on the display screen (131) indicating whether the one or more maxima includes the second maximum.

3. The device of claim 1, further comprising a display screen (131) operatively coupled to the processor (103), wherein the processor is further configured to display a directional indicator on the display screen indicating a direction toward an origination point of the second maximum when the one or more maxima includes the second maximum.

4. The device as in any of the preceding claims, further comprising a transceiver (309) operatively coupled to the processor (103), wherein the processor is configured to transmit confirmation data to a server when the one or more maxima includes the second maximum.

5. The device of claim 4, wherein the confirmation data includes a second intensity of the second maximum and at least one of a time and date stamp, a device identifier, a device location identifier, a device user identifier, image data, video data, and audio data.

6. The device as in any of claims 1-4, wherein the processor (103) is further configured to determine a second intensity and a second direction associated with the second maximum when the one or more maxima includes the second maximum.

7. The device as in any of the preceding claims, wherein the processor (103) is configured to apply a threshold filter to ignore the data associated with the first maximum.

8. The device of claim 7, wherein the processor (103), applying the threshold filter, is configured to compare the measured intensities against a predetermined threshold value.

9. A system for preventing loss of an object from a sales floor, the system comprising:
a first loss prevention device comprising: a first device as claimed in claim 1, a loss prevention device positioned at a point of egress from the sales floor and configured to detect a loss event indicia and to communicate detection of the loss event indicia,
wherein the first device is activated following communication of the detected loss event indicia.

10. The system of claim 9, further comprising a display screen (131) operatively coupled to the processor (103), wherein the processor is further configured to display a visual indicator on the display screen indicating whether the one or more maxima includes the second maximum.

11. The system of claim 9, further comprising a display screen (131) operatively coupled to the processor (103), wherein the processor is further configured to display a directional indicator on the display screen indicating a direction toward an origination point of the second maximum when the one or more maxima includes the second maximum.

12. The system as in any of claims 9-11, further comprising a wireless transceiver (309) operatively coupled to the processor (103), wherein the processor is configured to transmit confirmation data to a server when the one or more maxima includes the second maximum.

13. A method for detecting the presence of an unauthorized magnetic detacher of anti-theft tags, the method comprising:
measuring intensities and directions of one or more maxima in a magnetic field with a magnetometer (107), the one or more maxima including a first maximum from magnetic north of the Earth, wherein a first intensity and a first direction are associated with the first maximum;
ignoring the first intensity and the first direction associated with the first maximum; and
determining whether the one or more maxima includes a second maximum distinct from the first maximum.

14. The method of claim 13, further comprising transmitting confirmation data to a server when the one or more maxima includes the second maximum.

15. The method of claim 14, wherein the confirmation data includes a second intensity of the second maximum and at least one of a time and date stamp, a device identifier, a device location identifier, a device user identifier, image data, video data, and audio data.

## Patentansprüche

1. Vorrichtung zum Detektieren der Anwesenheit eines nicht autorisierten Magnetentfernungsgerätes für Antidiebstahlsanhänger bzw. -Tags, wobei die Vorrichtung Folgendes aufweist:
ein Magnetmessgerät (107), das konfiguriert ist, um Intensitäten und Richtungen von einem oder mehreren Maxima in einem Magnetfeld zu messen, wobei das eine oder die mehreren Maxima ein erstes Maximum vom magnetischen Nordpol der Erde aufweist, wobei eine erste Intensität und eine erste Richtung mit dem ersten Maximum assoziiert sind; und
einen Prozessor (103), der betriebsmäßig mit dem Magnetmessgerät (107) gekoppelt ist und konfiguriert ist, um die erste Intensität und die erste Richtung zu ignorieren, die mit dem ersten Maximum assoziiert sind, und um zu bestimmen, ob das eine oder die mehreren Maxima ein zweites Maximum aufweisen, das sich von dem ersten Maximum unterscheidet und größer ist als dieses.

2. Vorrichtung nach Anspruch 1, die weiter einen Anzeigeschirm aufweist, der betriebsmäßig mit dem Prozessor (103) gekoppelt ist, wobei der Prozessor weiter konfiguriert ist, um eine sichtbare Anzeige auf dem Anzeigeschirm (131) anzuzeigen, die anzeigt, wo das eine oder die mehreren Maxima das zweite Maximum aufweisen.

3. Vorrichtung nach Anspruch 1, welche weiter einen Anzeigeschirm (131) aufweist, der betriebsmäßig mit dem Prozessor (103) gekoppelt ist, wobei der Prozessor weiter konfiguriert ist, um eine Richtungsanzeige auf dem Anzeigeschirm anzuzeigen, welche eine Richtung zu einem Ausgangspunkt des zweiten Maximums anzeigt, wenn das eine oder die mehreren Maxima das zweite Maximum aufweisen.

4. Vorrichtung nach einem der vorhergehenden Ansprüche, die weiter einen Transceiver bzw. Sender/Empfänger (309) aufweist, der betriebsmäßig mit dem Prozessor (103) gekoppelt ist, wobei der Prozessor konfiguriert ist, um Bestätigungsdaten zu einem Server zu übertragen, wenn das eine oder die mehreren Maxima das zweite Maximum aufweisen.

5. Vorrichtung nach Anspruch 4, wobei die Bestätigungsdaten eine zweite Intensität des zweiten Maximums und zumindest eines der Folgenden aufweisen: einen Zeit- und Datumsstempel, einen Vorrichtungsidentifikator, einen Vorrichtungslageidentifikator, einen Vorrichtungsanwenderidentifikator, Bilddaten, Videodaten und Audiodaten.

6. Vorrichtung nach einem der Ansprüche 1 - 4, wobei der Prozessor (103) weiter konfiguriert ist, um eine zweite Intensität und eine zweite Richtung zu bestimmen, die mit dem zweiten Maximum assoziiert sind, wenn das eine oder die mehreren Maxima das zweite Maximum aufweisen.

7. Vorrichtung nach einem der vorhergehenden Ansprüche, wobei der Prozessor (103) weiter konfiguriert ist, um einen Schwellenfilter anzuwenden, um die Daten zu ignorieren, die mit dem ersten Maximum assoziiert sind.

8. Vorrichtung nach Anspruch 7, wobei der Prozessor (103), der den Schwellenfilter anwendet, konfiguriert ist, um die gemessenen Intensitäten mit einem vorbestimmten Schwellenwert zu vergleichen.

9. System zum Verhindern eines Verlustes eines Objektes aus einem Verkaufsbereich, wobei das System Folgendes aufweist.
eine erste Verlustverhinderungsvorrichtung, die Folgendes aufweist:
eine erste Vorrichtung nach Anspruch 1,
eine Verlustverhinderungsvorrichtung, die an einem Ausgangspunkt des Verkaufsbereiches positioniert ist und konfiguriert ist, um Verlustereignisanzeichen zu detektieren und die Detektion der Verlustereignisanzeichen zu übermitteln,
wobei die erste Vorrichtung folgend auf die Übermittlung der detektierten Verlustereignisanzeichen aktiviert wird.

10. System nach Anspruch 9, welches weiter einen Anzeigeschirm (131) aufweist, der betriebsmäßig mit dem Prozessor (103) gekoppelt ist, wobei der Prozessor weiter konfiguriert ist, um eine sichtbare Anzeige auf dem Anzeigeschirm anzuzeigen, die anzeigt, wo das eine oder die mehreren Maxima das zweite Maximum aufweisen.

11. System nach Anspruch 9, welches weiter einen Anzeigeschirm (131) aufweist, der betriebsmäßig mit dem Prozessor (103) gekoppelt ist, wobei der Prozessor weiter konfiguriert ist, um eine Richtungsanzeige auf dem Anzeigeschirm anzuzeigen, die eine Richtung zu einem Ausgangspunkt des zweiten Maximums anzeigt, wenn das eine oder die mehreren Maxima das zweite Maximum aufweisen.

12. System nach einem der Ansprüche 9-11, welches weiter einen drahtlosen Tranceiver bzw. Sender/Empfänger (309) aufweist, der betriebsmäßig mit dem Prozessor (103) gekoppelt ist, wobei der Prozessor konfiguriert ist, um Bestätigungsdaten zu einem Server zu übertragen, wenn das eine oder die mehreren Maxima das zweite Maximum aufweisen.

13. Verfahren zum Detektieren der Anwesenheit eines nicht autorisierten Magnetentfernungsgerätes für Antidiebstahlsanhänger bzw. -Tags, wobei das Verfahren Folgendes aufweist:
Messen von Intensitäten und Richtungen von einem oder mehreren Maxima in einem Magnetfeld mit einem Magnetmessgerät (107)" wobei das eine oder die mehreren Maxima ein erstes Maximum vom magnetischen Nordpol der Erde aufweisen, wobei eine erste Intensität und eine erste Richtung mit dem ersten Maximum assoziiert sind;
Ignorieren der ersten Intensität und der erste Richtung, die mit dem ersten Maximum assoziiert sind, und
Bestimmen, ob das eine oder die mehreren Maxima ein zweites Maximum aufweisen, das sich von dem ersten Maximum unterscheidet.

14. Verfahren nach Anspruch 13, welches weiter aufweist, Bestätigungsdaten zu einem Server zu übertragen, wenn das eine oder die mehreren Maxima das zweite Maximum aufweisen.

15. Verfahren nach Anspruch 14, wobei die Bestätigungsdaten eine zweite Intensität des zweiten Maximums und mindestens eines der Folgenden aufweisen: einen Zeit- und Datumsstempel, einen Vorrichtungsidentifikator, einen Vorrichtungslageidentifikator, einen Vorrichtungsanwenderidentifikator, Bilddaten, Videodaten und Audiodaten.

## Revendications

1. Dispositif destiné à détecter la présence d'un détacheur magnétique non autorisé d'étiquettes antivol, le dispositif comprenant :
un magnétomètre (107) configuré de manière à mesurer des intensités et des directions d'un ou plusieurs maximums dans un champ magnétique, ledit un ou lesdits plusieurs maximums comprenant un premier maximum provenant du nord magnétique de la Terre, dans lequel une première intensité et une première direction sont associées au premier maximum ; et
un processeur (103) fonctionnellement couplé au magnétomètre (107) et configuré de manière à ignorer la première intensité et la première direction associées au premier maximum, et à déterminer si ledit un ou lesdits plusieurs maximums incluent un second maximum, distinct du premier maximum et supérieur à celui-ci.

2. Dispositif selon la revendication 1, comprenant en outre un écran d'affichage fonctionnellement couplé au processeur (103), dans lequel le processeur est en outre configuré de manière à afficher un indicateur visuel sur l'écran d'affichage (131), indiquant si ledit un ou lesdits plusieurs maximums incluent le second maximum.

3. Dispositif selon la revendication 1, comprenant en outre un écran d'affichage (131) fonctionnellement couplé au processeur (103), dans lequel le processeur est en outre configuré de manière à afficher un indicateur directionnel sur l'écran d'affichage, indiquant une direction vers un point d'origine du second maximum lorsque ledit un ou lesdits plusieurs maximums incluent le second maximum.

4. Dispositif selon l'une quelconque des revendications précédentes, comprenant en outre un émetteur-récepteur (309) fonctionnellement couplé au processeur (103), dans lequel le processeur est configuré de manière à transmettre des données de confirmation à un serveur, lorsque ledit un ou lesdits plusieurs maximums incluent le second maximum.

5. Dispositif selon la revendication 4, dans lequel les données de confirmation incluent une seconde intensité du second maximum et au moins l'un des éléments parmi un horodatage, un identifiant de dispositif, un identifiant d'emplacement de dispositif, un identifiant d'utilisateur de dispositif, des données d'image, des données vidéo et des données audio.

6. Dispositif selon l'une quelconque des revendications 1 à 4, dans lequel le processeur (103) est en outre configuré de manière à déterminer une seconde intensité et une seconde direction associées au second maximum, lorsque ledit un ou lesdits plusieurs maximums incluent le second maximum.

7. Dispositif selon l'une quelconque des revendications précédentes, dans lequel le processeur (103) est configuré de manière à appliquer un filtre à seuil pour ignorer les données associées au premier maximum.

8. Dispositif selon la revendication 7, dans lequel le processeur (103), dans le cadre de l'application du filtre à seuil, est configuré de manière à comparer les intensités mesurées à une valeur de seuil prédéterminée.

9. Système destiné à empêcher la perte d'un objet depuis une surface de vente, le système comprenant :
un premier dispositif de prévention de perte comprenant :
un premier dispositif selon la revendication 1 ;
un dispositif de prévention de perte positionné au niveau d'un point de sortie de la surface de vente et configuré de manière à détecter un indice d'événement de perte et à communiquer la détection de l'indice d'événement de perte ;
dans lequel le premier dispositif est activé suite à la communication de l'indice d'événement de perte détecté.

10. Système selon la revendication 9, comprenant en outre un écran d'affichage (131) fonctionnellement couplé au processeur (103), dans lequel le processeur est en outre configuré de manière à afficher un indicateur visuel sur l'écran d'affichage, indiquant si ledit un ou lesdits plusieurs maximums incluent le second maximum.

11. Système selon la revendication 9, comprenant en outre un écran d'affichage (131) fonctionnellement couplé au processeur (103), dans lequel le processeur est en outre configuré de manière à afficher un indicateur directionnel sur l'écran d'affichage, indiquant une direction vers un point d'origine du second maximum lorsque ledit un ou lesdits plusieurs maximums incluent le second maximum.

12. Système selon l'une quelconque des revendications 9 à 11, comprenant en outre un émetteur-récepteur sans fil (309) fonctionnellement couplé au processeur (103), dans lequel le processeur est configuré de manière à transmettre des données de confirmation à un serveur lorsque ledit un ou lesdits plusieurs maximums incluent le second maximum.

13. Procédé de détection de la présence d'un détacheur magnétique non autorisé d'étiquettes antivol, le procédé comprenant les étapes ci-dessous consistant à :
mesurer des intensités et des directions d'un ou plusieurs maximums dans un champ magnétique au moyen d'un magnétomètre (107), ledit un ou lesdits plusieurs maximums incluant un premier maximum provenant du nord magnétique de la Terre, dans lequel une première intensité et une première direction sont associées au premier maximum ; et
ignorer la première intensité et la première direction associées au premier maximum ; et
déterminer si ledit un ou lesdits plusieurs maximums incluent un second maximum distinct du premier maximum.

14. Procédé selon la revendication 13, comprenant en outre l'étape consistant à transmettre des données de confirmation à un serveur, lorsque ledit un ou lesdits plusieurs maximums incluent le second maximum.

15. Procédé selon la revendication 14, dans lequel les données de confirmation incluent une seconde intensité du second maximum et au moins l'un des éléments parmi un horodatage, un identifiant de dispositif, un identifiant d'emplacement de dispositif, un identifiant d'utilisateur de dispositif, des données d'image, des données vidéo et des données audio.
